# EUROPEAN PATENT APPLICATION

(11) **EP 1 486 830 A2**
(43) Date of publication of application: **15.12.2004**
(21) Application number: 04253499.0
(22) Date of filing: 11.06.2004
(51) Int. Cl.: G03F 7/20

(54) **Device manufacturing method**

(30) Priority: 11.06.2003 JP 2003166521
(71) Applicant: CANON KABUSHIKI KAISHA, Tokyo (JP)
(72) Inventor: Oguso, Makoto c/o Canon KK, Ohta-ku, Tokyo (JP)
(74) Representative: Beresford, Keith Denis Lewis

(57) **Abstract**

In an attempt to manufacture a diffraction optical element having a sharp shape, like a perpendicular sidewall, using an exposure apparatus, lowering of the resolving power by defocusing, etc. would deteriorate the perpendicular sidewall shape into a taper shape, and result in a large taper shape. Accordingly, the exposure apparatus arranges an imaging position of a projection optical system near the resist surface, and makes a pitch of dot patterns on a mask constant.

## Description

The present invention relates generally to a method for forming a three-dimensional shape, and more particularly to a method for manufacturing devices, such as semiconductor devices and optical elements including micro lenses, and diffraction gratings.

A circuit pattern for a semiconductor device manufactured by the photolithography technology generally is made by light transmitting and shielding parts on a mask (or reticle), and transferred onto a photosensitive material when the exposure light is irradiated onto the material.

In order to form the circuit pattern, prior art usually has not considered a resist's thickness direction but considered only a resist's width. However, control over a shape in the resist's thickness direction by partial adjustments of the exposure dose has recently been proposed in order to prevent disconnections in a semiconductor device (see, for example, Japanese Patent Application, Publication No. 63-289817). This reference utilizes characteristics of the photosensitive material that almost linearly changes the residual coating thickness according to the exposure dose.

A description will be given of Japanese Patent Application, Publication No. 63-289817, with reference to FIG. 5.

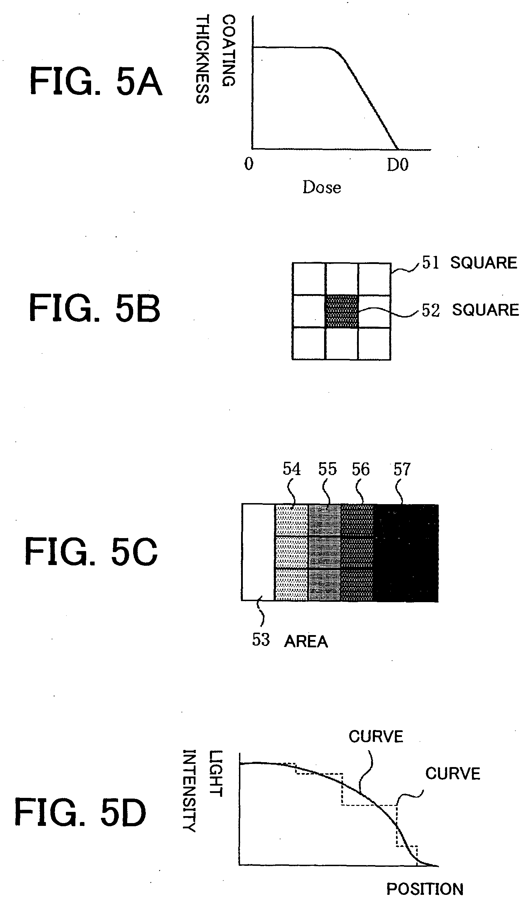

FIG. 5A is a characteristic (or photosensitive) curve of the positive-working resist. A relationship between the incident exposure energy and the coating thickness of the developed residual resist can be obtained by previously experimentally obtaining the characteristic curve of the positive-working resist shown in FIG. 5A. The minimum unit to be considered is 9 (or 3 x 3) pieces as shown in FIG. 5B. In FIG. 5B, 52 denotes a light shielding part, and 51 is a light transmitting part. FIG. 5C shows a mask that includes the minimum unit, and has areas 53 to 57 that changes a ratio between the number of light shielding parts 52 and the number of light transmitting parts 51 among 9 pieces.

More specifically, the area 53 has only the light transmitting parts 51 as the minimum unit. The area 54 has one light shielding part 52 among 9 pieces. The area 55 has two light shielding parts 52 among 9 pieces. The area 56 has four light shielding parts 54 among 9 pieces. The area 57 has five light shielding parts 52 among 9 pieces. The area 57 has only light shielding parts 52. The opening density distribution or the intensity distribution generated by the transmittance distribution is converted into the resist's coating thickness changes, as shown in FIG. 5D, by the sensitivity characteristic of the positive-working resist. Japanese Patent Application, Publication No. 63-289817 proposes to form the positive-working resist in a three-dimensional shape using the mask.

Recent optical elements have required spherical, aspheric and other special surface shapes for their refractive or reflective surfaces. In relation to a liquid crystal display device and a liquid crystal projector, etc., the micro lens, etc. have also required special surface shapes. Known as a method for forming refractive and reflective surfaces without molding and polishing is a method for forming a photoresist layer on an optical substrate, exposing the photoresist layer using an exposure mask having a two-dimensional transmittance distribution, and developing the photoresist to obtain a convex or concave photoresist surface shape. Thereafter, the photoresist and the optical substrate is subject to the anisotropic etching, and the photoresist's surface shape is engraved and transferred onto the optical substrate. The transfer provides a desired three-dimensional refractive or reflective surface shape on the optical substrate (see, for example, Japanese Patent Application, Publication No. 05-224398).

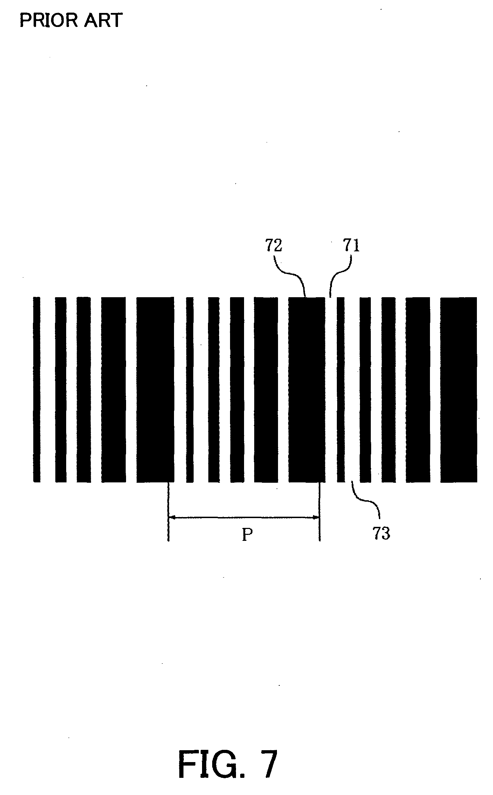

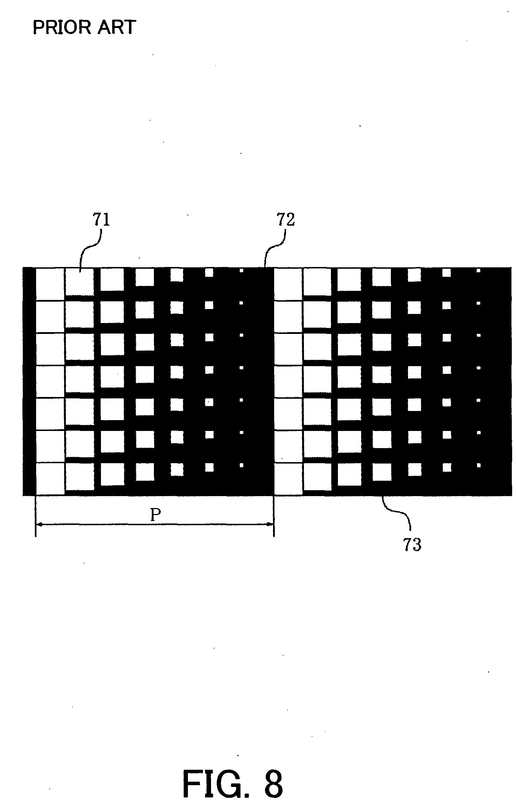

A description will be given of an embodiment in Japanese Patent Application, Publication No. 05-224398, with reference to FIGs. 7 and 8. Japanese Patent Application, Publication No. 05-224398 uses a resolvable period P to vary an area of an opening in a pattern that arranges non-resolvable openings 71 at a regular interval. Thereby, when the exposure light is irradiated onto the resist, a light intensity distribution expresses changes in opening ratio, while each opening pattern is not resolved. The opening ratio is designed from the residual coating characteristic of the resist to the exposure dose, and the exposed resist pattern by the generated light intensity distribution has a shape when the light intensity distribution is converted into the residual coating amount. The opening is not limited to a linear shape, and a method is also disclosed which forms the non-resolvable rectangular opening at a certain period (see FIG. 8). Moreover, a method is disclosed which adjusts resolving power by extremely defocusing a focus (or imaging) surface on the projection optical system (for example, by arranging the imaging surface at a position apart from a substrate surface opposite to the surface to which the resist is applied), depending upon an opening size formed on the mask.

The above prior art intentionally extremely deteriorates an exposure condition for the mask pattern, for example, by defocusing the imaging surface in the projection optical system in the exposure apparatus, so as to smooth the three-dimensional shape.

However, in an attempt to manufacture a diffraction optical element having a sharp shape like a perpendicular sidewall, lowering of the resolving power by defocusing, etc. would deteriorate the perpendicular sidewall shape into a taper shape, disadvantageously preventing a manufacture of a sharp shape like a desired perpendicular sidewall.

Accordingly, the instant inventor obtains the following knowledge through an experiment to reconcile the sharp shape and the smooth curved shape. The experiment employed a projection exposure apparatus that uses an i-line as a light source, as will be described later, and AZ-P4000 series (manufactured by Clariant Co.) that has a primary photosensitive wavelength in g-line for a resist.

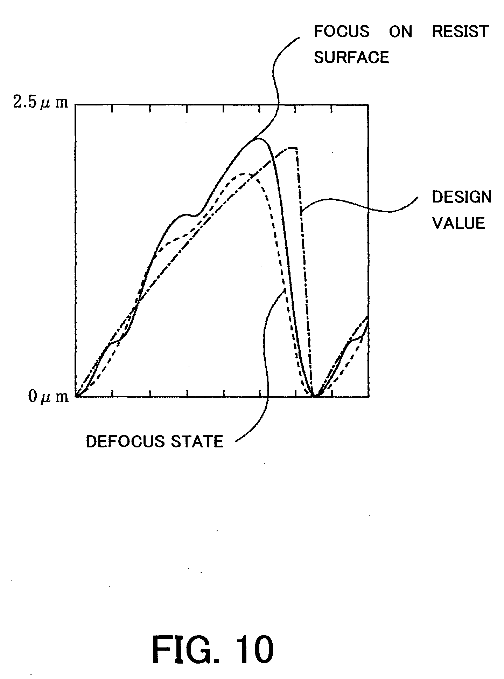

When the exposure was conducted while the imaging surface of the projection exposure apparatus was extremely defocused from the resist, the resist surface was definitely smooth. However, as shown in FIG. 10, the taper part becomes remarkable and an error from the design shape increases as the defocus amount increases. On the other hand, it is understood that when the imaging surface is focused on the resist surface, the taper part rises and approaches to the design value. Understandably, this means that the imaging surface is preferably set to or near the resist surface.

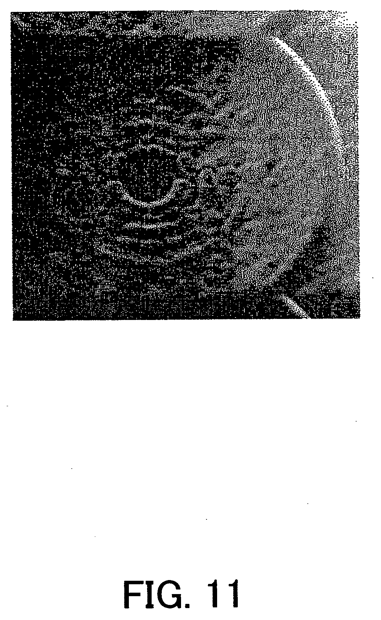

It has been discovered, however, that a problem arises when the imaging surface is set focused near the resist surface, especially where a mask for forming a three-dimensional shape changes a pattern pitch for each different transmittance area as disclosed in Japanese Patent Application, Publication No. 63-289817. This problem is due to pitches being different in every area, and dot patterns being close to or apart from each other at boundaries between adjacent areas. In an extreme case, dots extend over both adjacent areas as if large dots are arranged only at the boundary part, and a boundary's shape is transferred onto the resist. This influence on the light intensity distribution is small for design purposes, and indeed the density can be made uniform, for example, by setting a condition that the imaging surface on the projection optical system is defocused. However, as the focus position is set on or near the resist surface to reduce errors at the taper part, the slight light intensity distribution affects the resist shape (see FIG. 11).

Accordingly, embodiment of the present invention seeks to provide a three-dimensional shape forming method that solves the above disadvantages and provides a desired sharp three-dimensional shape.

A device manufacture method of one aspect according to the present invention includes the steps of preparing a mask that includes plural areas, each area including dot patterns arranged like a lattice at a constant, non-resolvable pitch, the dot patterns having substantially the same size in each area in the plural areas, and a size of the dot pattern being adjusted for each area, setting the mask in an exposure apparatus that includes an illumination optical system for illuminating the mask, and a projection optical system for introducing light from the mask into a substrate, arranging a photosensitive material so that a front surface of the photosensitive material is located near an image surface of a projection optical system, exposing the photosensitive material using light from the mask, and developing the photosensitive material that has been exposed, and forming a three-dimensional shape.

The arranging step may arrange the photosensitive material so that the image surface of the projection optical system is located between a bottom surface of the photosensitive material and a position apart from the front surface of the photosensitive material by a coating thickness of the photosensitive material.

Embodiments of the present invention will be described with reference to accompanying drawings.

FIG. 1 is a schematic view of a micro lens array having a three-dimensional shape to be formed by a first embodiment.

FIG. 2 is a partial sectional view of the lens shown in FIG. 1, for explaining a relationship between a contour and a micro lens array.

FIG. 3 is a partial enlarged sectional view for explaining sampling to a micro lens array.

FIG. 4 is an exemplary exposure curve of a positive-working resist.

FIG. 5 is a view for explaining a conventional example to form a three-dimensional shape on a photosensitive material.

FIG. 6 is a schematic plane view of a mask for forming a spherical surface as one lens element in the micro lens array.

FIG. 7 is a schematic plane view of a photomask used for the conventional, another fine patterning technology.

FIG. 8 is a schematic plane view of a photomask used for the conventional, still another fine patterning technology.

FIG. 9 is a view of a projection exposure apparatus used for the first embodiment.

FIG. 10 is a view of a tested sectional shape measurement result.

FIG. 11 is a drawing substituted photograph indicative of an observation result of the tested resist shape.

FIG. 12 is a view of a convex cylindrical mirror producible by an embodiment of the present invention.

FIG. 13 is a view of a concave cylindrical mirror producible by an embodiment of the present invention.

FIG. 14 is a view of an exposure apparatus.

The recent remarkable improvement of the mask manufacture technology has produced mask patterns having finer dots at a finer pitch than the conventional mask patterns.

When the transmittance was controlled by changing only a dot-pattern size while a pitch was maintained constant, a smooth curved surface could be obtained even though the projection optical system is focused near the resist surface.

Preferred embodiments of the present invention will now be described in detail in accordance with the accompanying drawings.

### FIRST EMBODIMENT

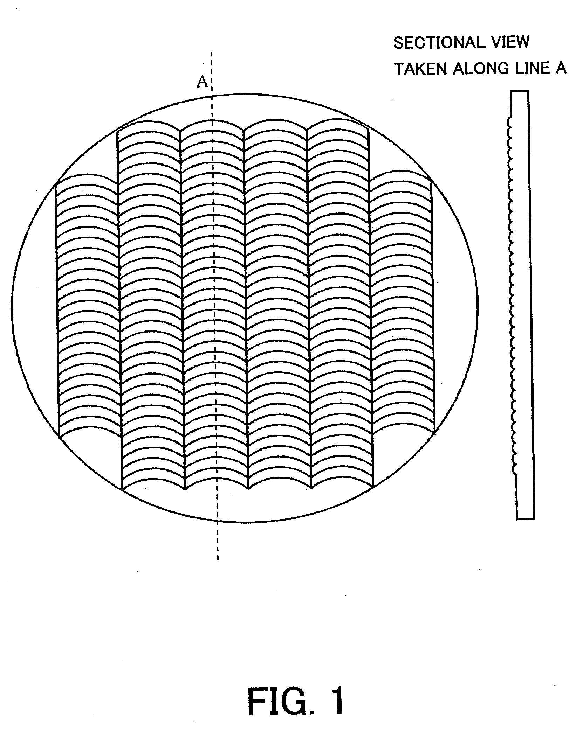

FIG. 1 shows a micro lens array 1, which includes plural arc-shaped element lenses.

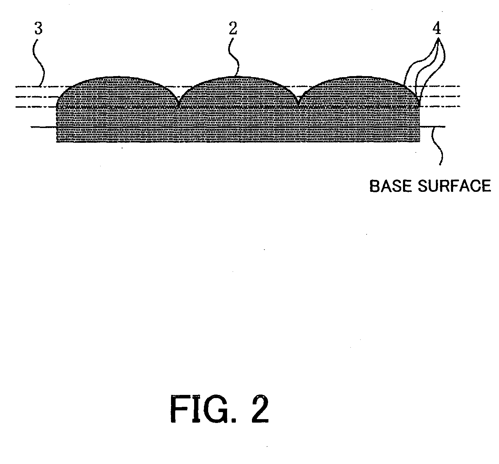

FIG. 2 observes a section of the arc-shaped element lens in the micro lens array 1, in which 2 denotes a surface shape in the observed section, and 3 denote several level lines from the substrate for sampling the sectional shape. Sampling of the lens surface with lines 3 provides contours each having the same height from the substrate.

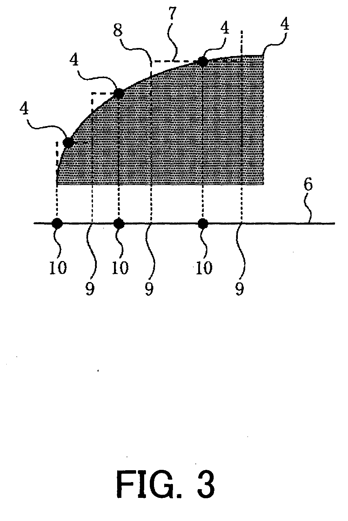

Intersections between the level lines 3 and the three-dimensional surface shape 2 define sampling points 4 (which actually form the contour). Plural areas are set based on these sampling points 4. As shown in FIG. 3, plural sampling points 4 are set on the surface shape 2.

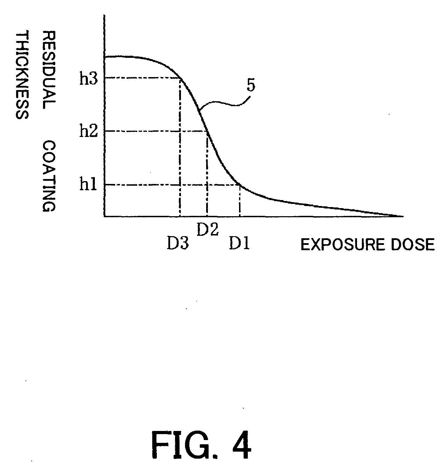

Then, midpoints are calculated between adjacent sampling points 10, which are sampling points 4 projected onto a substrate surface 6 as a reference plane. The midpoints provide area boundaries 9 for changing a mask's opening ratio to produce the three-dimensional shape. After the area boundaries 9 are set, the height in the area is represented by the height of the sampling point 4, and the opening ratio in the area is determined. The exposure dose corresponding to the representative height is calculated from a relationship between the exposure dose of the photosensitive material and the residual coating amount, which has been measured as shown in FIG. 4. A ratio of the exposure dose for each area to the maximum exposure dose and the transmittance are calculated where the maximum exposure dose is set to 100 in the three-dimensional shape. Our experiments have revealed that when a pattern smaller than the resolving limit is exposed, the opening ratio does not become substantially equal to the transmittance or a ratio of light passing through the mask, and thus requires a correction. Accordingly, a relationship between the opening ratio calculated from the size and the effective transmittance is previously calculated by comparing a result of that the exposure dose is changed using an opening having the transmittance corresponding to the exposure dose 100 with a result of that the exposure dose is changed by varying the opening ratio, and then the opening ratio is determined from the transmittance.

A three-dimensional shape of the photosensitive material finally obtained by controlling the mask's opening ratio is calculated as follows: Horizontal lines 7 are extended from the respective sampling points 4 and intersections 8 are calculated between the lines 7 and lines that extend from the area boundaries 9 in perpendicular directions. The three-dimensional shape of the photosensitive material is obtained from the designed mask by extending the lines 7 from the sampling points 4 to the intersections 8, and connecting level points via the intersections 8. It has been found that consecutive smooth curves can be obtained when the sampling pitch is sufficiently dense in view of the resolving power of the entire process including the resolving power of the photosensitive material.

Next, a mask is designed and produced based on the predetermined opening ratio. Since the target three-dimensional shape is an aggregation of plural arc-shaped element lenses, the base element lens is now addressed. Since the base element lens has a shape obtained by cutting a spherical lens in an arc shape, a description will now be given of the spherical lens.

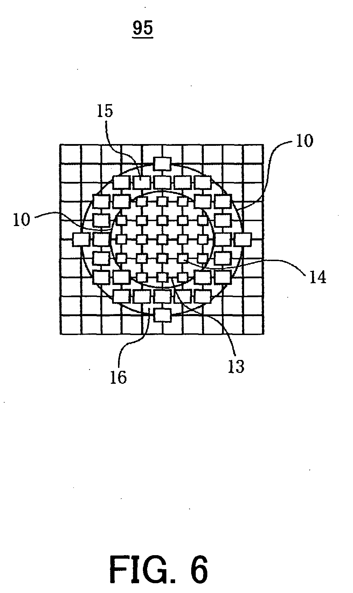

When the mask area 16 is designed using contours 3 as shown in FIG. 6, the area boundaries are concentric having its center at a center of the lens. FIG. 6 is a center part of mask 95 used for the instant embodiment.

Since a projection exposure apparatus uses i-line (having a wavelength of 365 nm) as a light source, a dot pattern is arranged on the whole surface at a uniform pitch of 0.4 µm with some latitude to the resolving limit. The uniform dot pitch on the mask can prevent occurrence of partial distribution swells in the opening ratio at boundaries between adjacent areas having different dot sizes.

Of course, 0.4 µm is a mere example, and the pitch size is selectable within an effective range. The number of dots increases and the transmittance changes slightly, as the pitch is smaller. A larger pitch would provide a wider range from the maximum dot size to the minimum dot size that is due to the manufacture limits, and fine control over a dot size. Anyway, it is noted that the high-performance mask manufacture is costly and the suitable pitch size changes in accordance with demands.

A size of the dot pattern is varied in accordance with the opening ratio for each area. The dot pattern may be a light transmitting or shielding part, depending on the type of resist used. For example, the opening ratio is 25 % when the light transmitting dots with a size half the pitch are arranged uniformly.

The dot patterns are arranged on lattice points at a desired pitch to draw a lattice, setting its origin at an origin of the circle as a base figure or a center of the area boundaries. A lattice is drawn even in the next outer area, setting its origin at an origin of the circle as a base figure, and the dot patterns are arranged on lattice points. The dot pattern having a designed dot size is arranged at a lattice point in a desired area.

Although FIG. 6 uses an orthogonal lattice, the lattice does not always need to be orthogonal and can be modified in accordance with three-dimensional shapes to be formed.

The mask design data is thus formed by designing a size of the dot pattern for each area, and taking out the design data with an outline of the base figure to be formed. For a lens array that has an outline of an arc shape, a mask pattern for forming a desired arc lens is formed by designing a spherical lens, determining a dot size distribution, and taking out an arc area having a desired size. Thereafter, the base pattern is repetitively arranged to produce the arc-shaped micro lens array mask.

While the above embodiment sets a center of the base figure at a center of the lattice for dot arrangements, the mask design allows a center of the mask to be located at the origin of the lattice for dot arrangements. An array shape often uses an approach that produces the mask design data with respect to the base figure and repeats the data of the base figure. Therefore, when the three-dimensional shape is an array of base figures, setting of an origin of the dot pattern arrangement (or an origin of the lattice) at the array of base figures facilitates the mask design and manufacture.

Next follows an exposure using a mask for a micro lens array.

A description will be given of an exposure apparatus used for the exposure. This exposure apparatus includes an illumination system 99 for illuminating a mask 95 shown in FIG. 6 using light (i-line) from a light source (not shown), and a projection optical system 92 for projecting a pattern on the mask 95 onto a substrate 90.

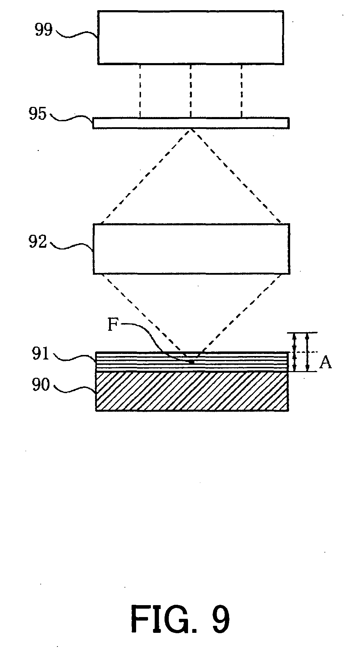

A resist 91, as a photosensitive material having a predetermined thickness, has been applied to the substrate 90. The instant embodiment arranges the substrate 90, as shown in FIG. 9, so that a surface of the resist 91 applied on the substrate 90 is located near the image surface of the projection optical system. Preferably, the image surface F (or the imaging position of the pattern on the mask 95) is located in a range A between a surface position of the substrate 90 (or a bottom surface of the resist 91) and a position not in contact with a front surface of the resist 91 by the resist's coating thickness.

The photosensitive material is shaped into a predetermined lens array by developing the exposed photosensitive material.

Since the imaging position of the projection optical system is arranged at or near the resist surface, a micro lens array whose sidewall has a small taper angle could be formed. In addition, the mask that arranged dot patterns at a single pitch could reduce a difference in exposure dose at an area boundary and form a micro lens array having a smooth curved surface.

The lens array made from the photosensitive material can be used as an optical element, as is. However, the instant embodiment makes the substrate 90 of quartz glass that can sufficiently transmit ultraviolet rays, in order to obtain an optical element viable to the ultraviolet light, and executes anisotropic dry etching using the resist having the micro lens array shape for a mask, transferring a shape of the micro lens array onto the quartz substrate. The anisotropic dry etching was conducted in a parallel plate type of reactive ion etching ("RIE") machine. The photosensitive material used a commercially available photoresist (Clariant Co., AZ-P4903 resist (product name)). Due to a subsequent process of transferring a shape onto the substrate using, as a mask, the photosensitive material that was properly shaped by anisotropic dry etching, etc., the resist material does not have to have optical characteristics of the optical element in addition to the photosensitivity. As discussed, since the instant embodiment arranges an imaging position of the projection optical system on or near the resist surface in the exposure apparatus and makes constant a pitch in the dot patterns on the mask, it creates the three-dimensional shape that is closer to the design value and sharper than the conventional one.

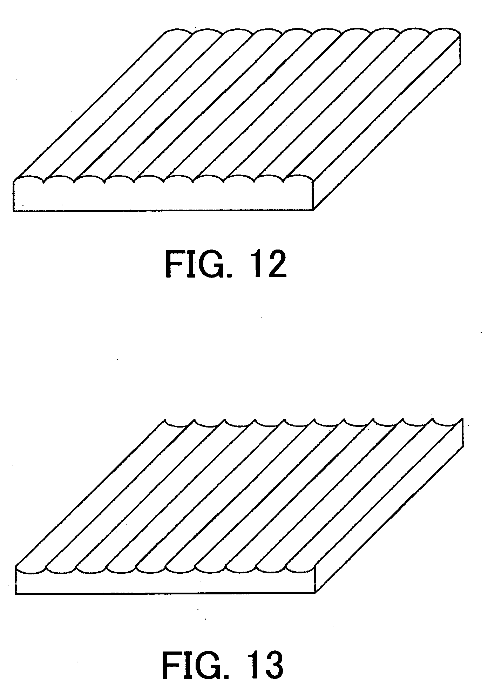

While the first embodiment discussed an arc-shaped lens array manufacture method, a similar method can similarly manufacture other optical elements, such as a diffraction optical element, a semiconductor element, a DNA chip. As shown in FIGs. 12 and 13, convex and concave cylindrical mirrors having plural cylindrical surfaces can be produced by a similar method of forming a mirror made from a Si / Mo multilayer coating on a predetermined three-dimensional shape transferred substrate. An illumination system in an exposure apparatus can use them as a reflective integrator. In particular, they are useful for an illumination system in an EUV exposure apparatus that uses EUV light with 5 to 20 nm as exposure light. FIG. 12 shows a convex cylindrical mirror, and FIG. 13 shows a concave cylindrical mirror.

### SECOND EMBODIMENT

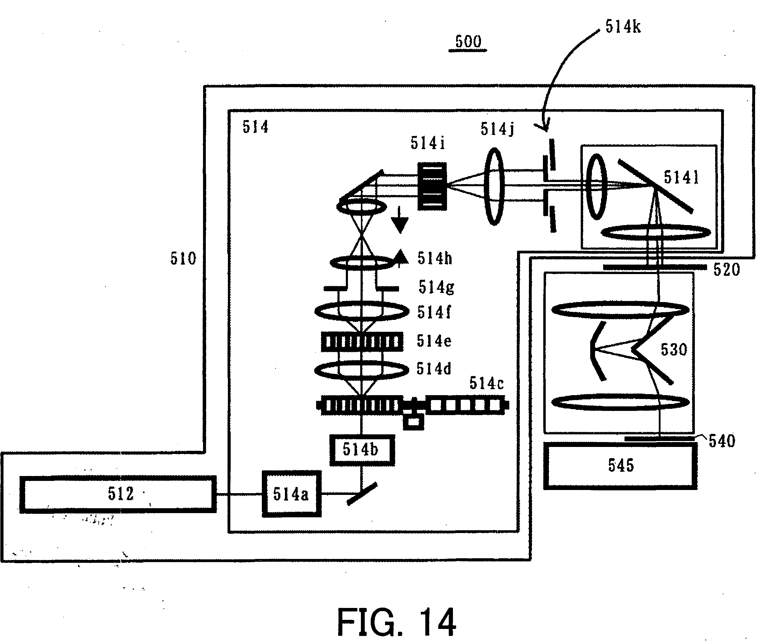

FIG. 14 is a schematic view of principal part in an exposure apparatus of a second embodiment according to the present invention. FIG. 14 is a schematic structure of the exposure apparatus 500 of one aspect according to the present invention. The exposure apparatus 500 includes, as shown in FIG. 14, an illumination apparatus 510, a mask (reticle) 520, a projection optical system 530, a substrate 540, and a stage 545.

The exposure apparatus 500 is a so-called scanning exposure apparatus that scans and exposes the substrate 540 using slit-shaped light from the projection optical system 530.

The illumination apparatus 510 illuminates the mask 520 that forms a circuit pattern to be transferred, and includes a light source section 512 and an illumination optical system 514.

The light source section 512 uses a F₂ excimer laser with a wavelength of approximately 157 nm as a light source. The light source can also use an ArF excimer laser and a KrF excimer laser, etc.

The illumination optical system 514 is an optical system for illuminating the mask 520, and includes a darkening means 514a, beam oscillating means 514b, a fly-eye lens 514c, a condenser lens 514d, a fly-eye lens 514e, a condenser lens 514f, an effective light source forming stop 514g, a zoom relay lens 514h, a fly-eye lens 514i, a condenser lens 514j, a masking blade 514k, and a masking imaging lens 5141.

The darkening means 514a controls the light intensity on the illuminated surface. In use of a pulse light source, such as F₂ laser, for the light source section 512, an exposure amount scatters due to scattering outputs among laser pulses. Therefore, it is necessary to reduce the scattering exposure amount by considering the number of exposure pulses to be the number of predetermined pulses or greater and by averaging scattering pulses. When the photosensitive agent has high sensitivity, the darkening means 514a darkens light to reduce the light intensity and expose with the number of predetermined pulses or greater.

The beam swing means 514b swings a beam from the light source section 512, and swings the speckle distribution to average speckles over time during exposure. The beam swing method includes a method for rotating an inclined parallel plate, a method for swinging a mirror, a method for rotating a wedge prism, etc. The instant embodiment uses coherent F₂ laser for the light source in the light source section 512, and thus speckles occur on the illuminated surface. Speckles occur due to non-uniform light intensity and scattering exposure amounts on the illuminated surface, and cause critical dimensions of resolved images from the mask 520 to the substrate 540 to disadvantageously differ according to locations (or deteriorate CD uniformity). Therefore, the beam swing means 514b is provided.

The fly-eye lens 514c forms a secondary light source on an exit surface, and Koehler-illuminates an incident surface of the fly-eye lens 514e through the condenser lens 514d. A turret arranges plural fly-eye lenses 514c, and can switch the exit NA from the fly-eye lens 514c, thereby changing an irradiation range on an incident surface of the fly-eye lens 514i. This is to avoid light condensing on the exit surface of the fly-eye lens 514i when the zoom relay lens 514h changes a magnification.

The fly-eye lens 514e forms a tertiary light source on an exit surface, and Koehler-illuminates the effective light source forming stop 514g through the condenser lens 514d. A double fly-eye lens structure from the fly-eye lens 514c to condenser lens 514f maintains a light distribution on the effective light source forming stop 514g even when the laser beam changes its profile, and can always form a uniform effective light source.

For example, without a fly-eye lens 514c and the condenser lens 514d, a change of a positional distribution from the laser changes the light intensity distribution on the incident surface of the fly-eye lens 514e and thus the light's angular distribution on the effective light source forming stop 514g. A change of the light's angular distribution shifts the light intensity distribution on the exit surface of the fly-eye lens 514i, which will be described later, and inclines the angular distribution on the substrate 540. When the substrate 540 defocuses, a transfer position changes (on-axis telecentricity). Therefore, a double fly-eye lens structure is used from the fly-eye lens 514c to condenser lens 514f.

The effective light source forming stop 514g defines the effective light source that is a light source for illuminating the mask 520. The effective light source usually has a circular shape. On the other hand, the fly-eye lens 514e uses a rectangular fly-eye lens in which its rod lens has a rectangular outline, a hexagonal fly-eye lens in which its rod lens has a hexagonal outline, and a cylindrical lens array that arranges cylindrical lens arrays as element lenses. Therefore, the distribution formed on the effective light source forming stop 514g at the light source section 512 would have a square shape for the rectangular fly-eye lens and cylindrical lens array, and a hexagonal shape for the hexagonal lens array. Therefore, the effective light source forming stop 514g having a circular opening is needed to form a circular effective light source.

The zoom relay lens 514h projects a circular light intensity distribution formed on the effective light source forming stop 514g, onto the incident surface of the fly-eye lens 514i at a predetermined magnification. A size of the light source that illuminates the mask 520 is referred to as a coherent factor, and required to be variable according to a pattern to be transferred so as to improve performance of the projection optical system 530. Accordingly, a size of the illuminated area on the incident surface of the fly-eye lens 514i is made variable by making variable the magnification of the relay optical system of the zoom relay lens 514h.

The fly-eye lens 514i forms a quaternary light source on an exit surface, and illuminates the masking blade 514k with a uniform light intensity distribution through the condenser lens 514j. The fly-eye lens 514i uses an arc-shaped fly-eye lens since the projection optical system 530 has a circular imaging area and the mask 520 should be illuminated with an arc shape. This arc-shaped fly-eye lens is a micro lens array manufactured by a device manufacture method of the above first embodiment.

The exposure apparatus 500 is a scanning exposure apparatus and can correct non-uniform exposure amount in the perpendicular direction by changing a width of the arc illumination area. For example, it is desirable to switch plural fly-eye lenses 514i having different arc widths arranged on a turret for an adjustment to the arc width.

The masking blade 514k controls an exposure area, and is driven according to a scan area to obtain desired exposure area.

The masking imaging lens 5141 projects a light intensity distribution on the masking blade 514k onto the mask 520.

The illumination optical system 514 uses the fly-eye lenses 514c, 514e and 514i formed by the three-dimensional structure forming method described above, and maintains desired optical performance.

The mask 520 forms a circuit pattern (or an image) to be transferred and is supported and driven by a mask stage (not shown). The mask 520 is made of a material having high transmittance to a wavelength of 157 nm, such as F-doped quartz and calcium fluoride. Diffracted light from the mask 520 passes through the projection optical system 530, and is projected onto the substrate 540. The mask 520 and the substrate 540 are disposed in an optically conjugate relationship. Since the exposure apparatus 500 of the instant a scanning exposure apparatus, a scan of the mask 520 and the substrate 540 at a reduction speed ratio transfers the pattern on the mask 520 onto the object 540.

The projection optical system 530 is a catadioptric optical system that has plural lens and at least one concave mirror. The projection optical system 530 uses lenses and a mirror for achromatism and maintains good imaging performance in arc imaging area. The substrate 540 is an object to be exposed, such as a wafer and a liquid crystal substrate, and photoresist is applied onto the substrate 540.

The stage 545 supports the substrate 540. The stage 545 can use any structure known in the art, and a detailed description of its structure and operation will be omitted. The stage 545 uses, for example, a linear motor to move the substrate 540 in -X-Y-Z directions. The positions of the stage (not shown) and stage 545 are monitored, for example, by a laser interferometer and the like, so that both are driven at a constant speed ratio.

In exposure, a F₂ laser beam emitted from the light source section 512 Koehler-illuminates the mask 520 through the illumination optical system 514. This light transmits the mask 520 and reflects a mask pattern images on the substrate 540 through the projection optical system 530. The fly-eye lenses 514c, 514e and 514i in the illumination optical system in the exposure apparatus 500 are formed by the above-described three-dimensional structure forming method, and can maintain optical performance. In addition, the fly-eye lens 514i can use an arc fly-eye lens, and the substrate 540 can maintain high light intensity on its surface. As a result, higher quality devices, such as semiconductor devices, LCD devices, image-pickup elements (*e.g.*, CCD), and thin-film magnetic heads, than the conventional, can be provided with high throughput and good economic efficiency.

As many apparently widely different embodiments of the present invention can be made without departing from the spirit and scope thereof, it is to be understood that the invention is not limited to the specific embodiments thereof.

It will be understood that in both the first and the second embodiments, after exposure and development of the resist and any etching step, further device manufacturing and finishing stages may be carried out as desired, such as separating the substrate into multiple devices.

## Claims

1. A device manufacture method comprising the steps of:
preparing a mask that includes plural areas, each area including a pattern of dots arranged like a lattice at a constant, non-resolvable pitch, the dots having substantially the same size within each area in the plural areas, and a size of the dots being adjusted for each area;
setting the mask in an exposure apparatus that includes an illumination optical system for illuminating the mask, and a projection optical system for introducing light from the mask into a substrate;
arranging a photosensitive material so that a front surface of the photosensitive material is located near an image surface of a projection optical system;
exposing the photosensitive material using light from the mask; and
developing the photosensitive material that has been exposed, and forming a three-dimensional shape.

2. A method according to claim 1, wherein said arranging step arranges the photosensitive material so that the image surface of the projection optical system is located between a bottom surface of the photosensitive material and a position apart from the front surface of the photosensitive material by a coating thickness of the photosensitive material.

3. A method according to claim 1, wherein the three-dimensional shape is an arrangement of a plurality of parts of a base figure, and
wherein the dots are arranged on lattice points having an origin of the base figure.

4. A method according to claim 3, wherein the base figure is a circle, and the part of the base figure has an arc shape.

5. A method according to claim 1, wherein the photosensitive material is formed on the substrate.

6. A method according to claim 5, further comprising the step of etching the substrate using, as a mask, the photosensitive material that has been developed, and of transferring a shape of the photosensitive material onto the substrate.

7. A method according to claim 1, wherein the dots are located on lattice points.

8. A method according to claim 1, wherein the dots shield light from a light source.

9. A method according to claim 1, wherein the dots transmit light from a light source.

10. A mask for use in exposing an object with radiation having an intensity distribution influenced by the mask, the mask having a pattern of dots arranged at a constant pitch, the dots having different sizes in different regions of the mask.

11. A mask according to claim 10 in which the said constant pitch is not resolvable with light of a wavelength of 365nm.

12. A method of manufacturing a device comprising: (a) exposing a layer of photoresist with light projected from a mask according to claim 10 or claim 11, an image of the mask being formed on the layer of photoresist without substantial de-focus and the pitch of the pattern of dots not being resolved on the photoresist; (b) developing the exposed photoresist to obtain a three-dimensional shape in accordance with the distribution of dot size across the mask; and (c) manufacturing one or more devices from or by use of the exposed photoresist.

13. An optical element manufactured by a method according to any one of claims 1 to 9 and 12.

14. An exposure apparatus comprising:
an illumination optical system for illuminating a mask, said illumination optical system includes the optical element according to claim 13; and
a projection optical system for introducing light from the mask into a substrate.

15. A method of manufacturing a device comprising exposing an object to a pattern of radiation using an exposure apparatus according to claim 14, developing the exposed object, and making one or more devices from the exposed object.
